# EUROPÄISCHE PATENTANMELDUNG

(11) **EP 2 320 459 A2**
(43) Veröffentlichungstag der Anmeldung: **11.05.2011**
(21) Anmeldenummer: 10177049.3
(22) Anmeldetag: 16.09.2010
(51) Int. Cl.: H01L 25/07

(54) **Leistungshalbleitermodul**

(30) Priorität: 04.11.2009 DE 102009046403
(71) Anmelder: SEMIKRON Elektronik GmbH & Co. KG, 90431 Nürnberg (DE)
(72) Erfinder: Frank, Thomas, 91207, Lauf (DE)

(57) **Zusammenfassung**

Die Erfindung betrifft ein Leistungshalbleitermodul, bei dem ein mit zumindest einem Leistungshalbleiter (8) versehenes Substrat (7) erste (10) und zweite Kontaktflächen (11) aufweist, wobei ein erstes Lastanschlusselement (1) mit daran vorgesehenen ersten Kontaktelementen (3) auf den ersten Kontaktflächen (10) und ein zweites Lastanschlusselement (2) mit daran vorgesehenen zweiten Kontaktelementen (4) auf den zweiten Kontaktflächen (11) abgestützt ist, und wobei zumindest ein Federelement (19) zur Erzeugung eines Druckkontakts zwischen den Kontaktelementen (3, 4) und den Kontaktflächen (10, 11) vorgesehen ist. Zur Verminderung der Baugröße ist erfindungsgemäß vorgesehen, dass der Druckkontakt zwischen den Kontaktelementen (3, 4) und den Kontaktflächen (10, 11) über zumindest ein zwischen dem Federelement (19) und einem der Lastanschlusselemente (1, 2) angeordnetes elektrisches Bauelement (12) ausgeübt wird.

## Beschreibung

Die Erfindung betrifft ein Leistungshalbleitermodul nach dem Oberbegriff des Anspruchs 1.

Ein solches Leistungshalbleitermodul ist aus der DE 10 2006 006 425 B4 bekannt. Bei dem bekannten Leistungshalbleitermodul ist ein erste und zweite Kontaktflächen aufweisendes Substrat mit seiner den Kontaktflächen abgewandten Unterseite auf einem Kühlkörper abgestützt. Auf der gegenüberliegenden Oberseite sind Leistungshalbleiter montiert, welche mit den Kontaktflächen elektrisch leitend verbunden sind. Die Kontaktflächen dienen beispielsweise zur Verbindung mit einer Stromquelle. Zu diesem Zweck können aus Blechen hergestellte Lastanschlusselemente vorgesehen sein, von denen sich Kontaktfüße erstrecken. Zur Herstellung eines elektrischen Kontakts werden die Lastanschlusselemente mit ihren Kontaktfüßen auf den Kontaktflächen abgestützt. Um einen so hergestellten Kontakt unempfindlich gegen Erschütterungen, Stöße und dgl. zu machen, wird auf die Lastanschlusselemente ein Druck ausgeübt, welche deren Kontaktfüße gegen die Kontaktflächen zwingt. Zu diesem Zweck können die Lastanschlusselemente mittels zumindest eines Federelements, mittels einer komprimierten elastischen Schicht, einer Druckfeder oder dgl. gegen die Kontaktflächen gezwungen werden.

Bei derartigen Leistungshalbleitermodulen sind mitunter oberhalb der Lastanschlusselemente weitere Bauelemente und/oder mit Schaltungen versehene Platinen verbaut. Bei den Bauelementen kann es sich beispielsweise um Elektrolytkondensatoren und bei den Schaltungen um Steuerschaltungen zum Ansteuern der Leistungshalbleiter handeln. Wenn oberhalb der Lastanschlusselemente Bauelemente und/oder mit Schaltungen versehene Platinen verbaut sind, ist zur Schonung derartiger Komponenten üblicherweise eine fest mit dem Kühlkörper verbundene Gehäusehalbschale vorgesehen, gegen welche das Federelement abgestützt ist. Infolgedessen ist also das Federelement neben den Bauelementen angeordnet. In einer Platine kann beispielsweise ein Durchbruch zum Durchführen des Federelements vorgesehen sein. Das Nebeneinander zwischen Federelement und Bauelementen erfordert einen relativ hohen Platzbedarf. Das Vorsehen eines Durchbruchs in einer Platine ist aufwändig, trägt außerdem zu deren Vergrößerung und damit wiederum zu einem hohen Platzbedarf bei.

Aufgabe der Erfindung ist es, die Nachteile nach dem Stand der Technik zu beseitigen. Es soll insbesondere ein möglichst kompaktes Leistungshalbleitermodul angegeben werden, welches einfach und kostengünstig herstellbar ist.

Diese Aufgabe wird durch die Merkmale des Anspruchs 1 gelöst. Zweckmäßige Ausgestaltungen der Erfindung ergeben sich aus den Merkmalen der Ansprüche 2 bis 11.

Nach Maßgabe der Erfindung ist vorgesehen, dass der Druckkontakt zwischen den Kontaktelementen und den Kontaktflächen über zumindest ein, zwischen den Federelementen und einem der Lastanschlusselemente angeordnetes elektrisches Bauelement ausgeübt wird. - In Abkehr vom Stand der Technik wird erfindungsgemäß vorgeschlagen, dass der Druckkontakt nunmehr über ein auf dem Lastanschlusselement abgestütztes elektrisches Bauelement hergestellt wird. Zu diesem Zweck übt das Federelement einen Druck auf das Bauelement aus, welcher von da auf das Lastanschlusselement übertragen wird. Indem das Federelement nunmehr oberhalb des Bauelements angeordnet ist, kann insgesamt eine kompaktere Bauweise erreicht werden.

Im Sinne der vorliegenden Erfindung wird unter dem Betriff "Federelement" allgemein ein elastisches Element verstanden, welches bei Kompression eine elastische Rückstellkraft ausübt. Bei dem Federelement kann es sich um eine Spiralfeder, eine flexible Federzunge, ein elastisch komprimierbares Material, welches beispielsweise aus Gummi, einem elastischen Polymer, einem elastischen Schaumstoff oder dgl., hergestellt sein kann, oder dgl. handeln. Unter dem Begriff "elektrisches Bauelement" wird ein Bauelement verstanden, welches Bestandteil einer Schaltung des Leistungshalbleitermoduls ist. Das elektrische Bauelement ist im Wesentlichen starr ausgebildet, so dass damit eine durch das Federelement ausgeübte Kraft auf das Lastanschlusselement übertragen wird.

Bei dem elektrischen Bauelement handelt es sich insbesondere um einen Kondensator, vorzugsweise einen Elektrolytkondensator. Elektrolytkondensatoren sind häufig relativ großvolumig ausgebildet. Bei Leistungshalbleitermodulen mit Elektrolytkondensatoren kann unter Verwendung der vorgeschlagenen Erfindung eine besonders kompakte Bauweise erreicht werden.

Nach einer weiteren Ausgestaltung der Erfindung ist ein den Kondensator aufnehmendes oberes Gehäuseelement mit einem dazu korrespondierenden, das Substrat aufnehmenden oder durch das Substrat gebildeten, unteren Gehäuseelement verbunden. Das obere und/oder untere Gehäuseelement können beispielsweise aus spritzgegossenem Kunststoff hergestellt sein. Im unteren Gehäuseelement kann ein Kühlkörper aufgenommen sein, auf welchen das Substrat abgestützt ist. Es kann aber auch sein, dass das untere Gehäuseelement selbst aus einem Kühlkörper gebildet ist. In diesem Fall kann das untere Gehäuseelement beispielsweise aus Aluminium hergestellt sein.

Vorteilhafterweise weist das obere Gehäuseelement eine zylindrische Ausnehmung zur im Wesentlichen formschlüssigen Aufnahme des Kondensators auf. Der Kondensator ist in die zylindrische Ausnehmung bei der Montage einsteckbar. Er wird in der zylindrischen Ausnehmung gleitverschiebbar gehalten.

Das Federelement kann zwischen einer Decke der Ausnehmung und einem in der Ausnehmung aufgenommenen Kondensator vorgesehen sein. Zweckmäßigerweise ist das Federelement aus einem dauerelastischen Schaumstoffelement hergestellt oder nach Art einer Federzunge gebildet. Das Federelement ist zweckmäßigerweise an der Decke der Ausnehmung angeformt. Es kann beispielsweise aus einer an der Decke angeformten Federzunge gebildet sein.

Nach einer weiteren Ausgestaltung der Erfindung ist ein sich vom Kondensator erstreckender erster Anschluss mit einem der ersten Kontaktelemente und ein sich vom Kondensator erstreckender zweiter Anschluss mit einem der zweiten Kontaktelemente verbunden. D. h. der Kondensator ist also unmittelbar mit den Lastanschlusselementen verbunden.

Das zweite Lastanschlusselement weist zumindest einen Durchbruch auf, durch welchen eines der ersten Kontaktelemente und/oder ein erster Anschluss hindurchgeführt ist/sind. Damit kann weiter die Baugröße des Leistungshalbleitermoduls reduziert werden.

Die Anschlüsse können mit den Kontaktelementen verlötet oder verschweißt sein. Es kann aber auch sein, dass die Anschlüsse zwischen den Kontaktflächen und den Kontaktelementen klemmend gehalten sind. Das vereinfacht die Herstellung des Leistungshalbleitermoduls. Eine Klemmkraft zum Halten der Anschlüsse wird zweckmäßigerweise durch das Federelement erzeugt, welche die Kontaktelemente gegen die Kontaktflächen zwingt.

Nachfolgend wird ein Ausführungsbeispiel der Erfindung anhand der Zeichnungen näher erläutert. Es zeigen:

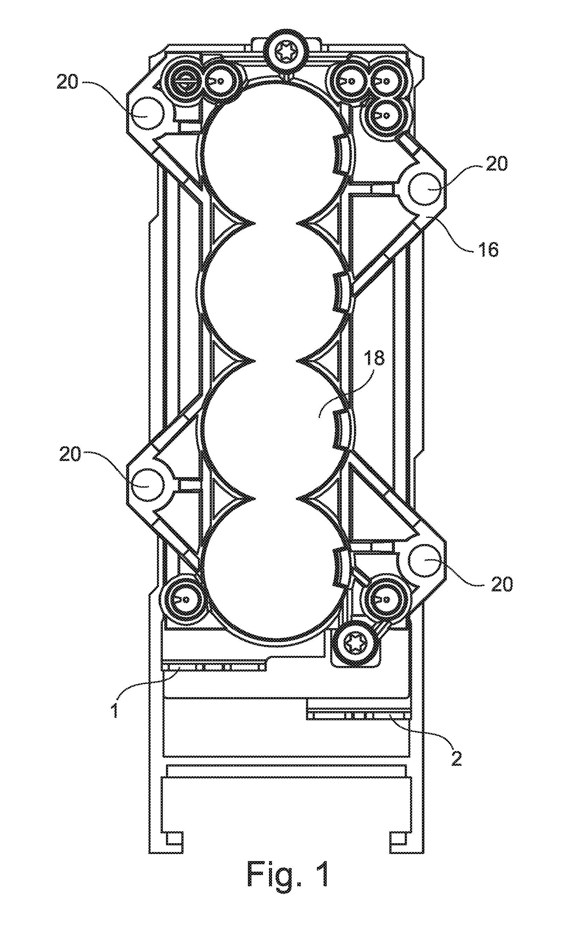

- Fig. 1: eine Draufsicht auf ein Leistungshalbleitermodul,

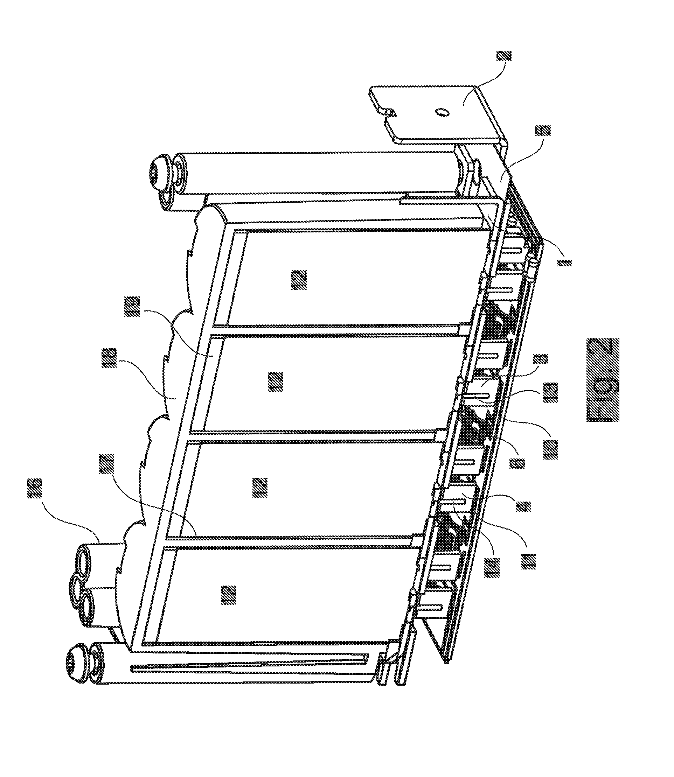

- Fig. 2: eine erste perspektivische Schichtansicht gemäß Fig. 1 und
- Fig. 3: eine zweite perspektivische Schnittansicht gemäß Fig. 1.

In den Figuren ist mit dem Bezugszeichen 1 ein erstes Lastanschlusselement und mit dem Bezugszeichen 2 ein zweites Lastanschlusselement bezeichnet. Das erste 1 und das zweite Lastanschlusselement 2 ist jeweils aus einem plattenförmigen Metallkörper gebildet, welcher sich davon erstreckende erste Kontaktfüße 3 und zweite Kontaktfüße 4 aufweist. Das erste 1 und das zweite Lastanschlusselement 2 sind unter Zwischenschaltung einer elektrisch isolierenden Schicht 5 übereinander gestapelt. Das zweite Lastanschlusselement 2 und die elektrisch isolierende Schicht 5 weisen jeweils Durchbrüche 6 auf, durch welche die ersten Kontaktfüße 3 hindurchgeführt sind.

Mit dem Bezugszeichen 7 ist ein, beispielsweise in DCB-Technik hergestelltes, Substrat bezeichnet, auf dem Leistungshalbleiter 8 aufgenommen sind. Die Leistungshalbleiter 8 sind über Bondingdrähte 9 mit ersten Kontaktflächen 10 und zweiten Kontaktflächen 11 verbunden. Die ersten 10 und/oder die zweiten Kontaktflächen 11 können auch aus einer Mehrzahl nebeneinander angeordneter, auf dem Substrat 7 aufliegender Bondingdrähte 9 gebildet sein. Die ersten Kontaktfüße 3 sind in elektrischem Kontakt mit den ersten Kontaktflächen 10; die zweiten Kontaktfüße 4 sind in elektrischen Kontakt mit den zweiten Kontaktflächen 11.

Mit dem Bezugszeichen 12 sind Elektrolytkondensatoren bezeichnet, deren erste Anschlüsse 13 mit den ersten Kontaktfüßen 3 und deren zweite Anschlüsse 14 jeweils mit den zweiten Kontaktfüßen 4 elektrisch verbunden sind. Die Verbindung kann dabei beispielsweise mittels Löten oder Schweißen erfolgen. Es ist auch denkbar, dass die ersten 13 und/oder zweiten Anschlüsse 14 um eine Unterkante der Kontaktfüße 3, 4 herumgeführt und klemmend zwischen den Kontaktfüßen 3, 4 und den Kontaktflächen 10, 11 gehalten sind. Zu diesem Zweck kann im Bereich der Unterkante der Kontaktfüße 3, 4 eine Ausnehmung zum Einlegen der Anschlüsse 13, 14 vorgesehen sein (hier nicht gezeigt).

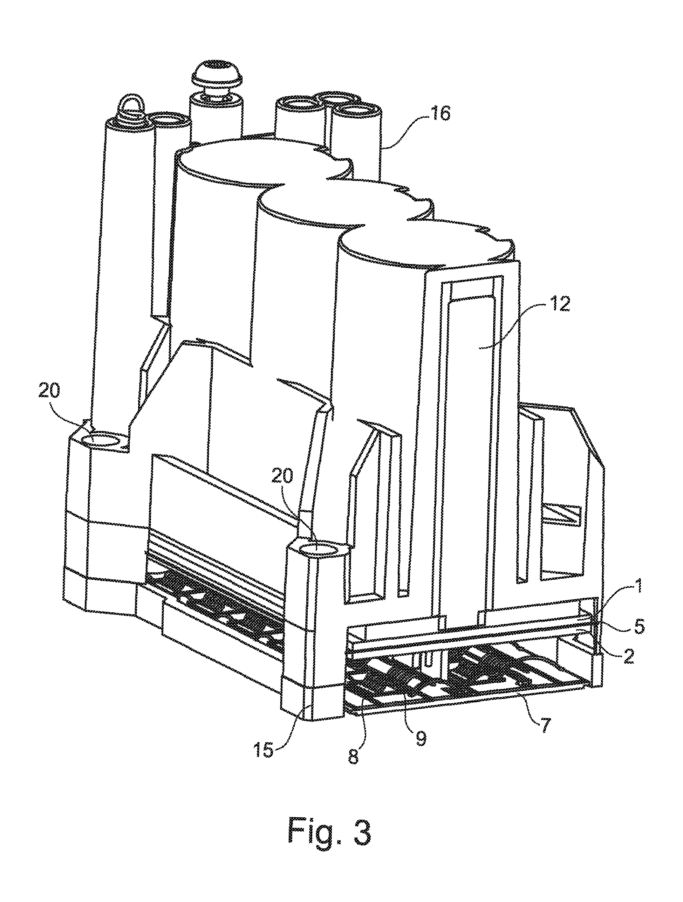

Wie insbesondere aus Fig. 3 ersichtlich ist, ist das Substrat 7 in einem unteren Gehäuseelement 15 aufgenommen. Mit dem Bezugszeichen 16 ist ein oberes Gehäuseelement bezeichnet, welches für jeden der Elektrolytkondensatoren 12 eine zylindrische Ausnehmung 17 aufweist. Die Elektrolytkondensatoren 12 sind gleitverschiebbar in die zylindrischen Ausnehmungen 17 eingesteckt. Eine Decke 18 schließt jede der zylindrischen Ausnehmungen 17 ab. Zwischen der Decke 18 und den Elektrolytkondensatoren 12 ist ein hier in Form eines elastischen komprimierbaren Schaumstoffelements 19 ausgebildetes Federelement eingelegt. Das Schaumstoffelement 19 ist zweckmäßigerweise nach Art einer Scheibe ausgeführt.

Zur Montage des Leistungshalbleitermoduls werden zunächst die elektrisch isolierende Schicht 5 und darauf das zweite Lastanschlusselement 2 auf das erste Lastanschlusselement 1 so gestapelt, dass die ersten Kontaktfüße 3 durch die in der elektrisch isolierenden Schicht 5 und dem zweiten Lastanschlusselement vorgesehenen Durchbrüche 6 hindurchgeführt werden. Sodann werden die ersten Anschlüsse 13 der Elektrolytkondensatoren 12 mit den ersten Kontaktfüssen 3 des ersten Lastanschlusselements 1, beispielsweise mittels Löten oder Reibschweißen, verbunden. Anschließend werden die zweiten Anschlüsse 14, beispielsweise wiederum durch Löten oder Reibschweißen, mit den zweiten Kontaktfüßen 4 verbunden. Dann werden die Elektrolytkondensatoren 12 in die zylindrischen Ausnehmungen 17 eingesteckt. Schließlich wird das obere Gehäuseelement 14 mittels durch in Schraubenbohrungen 20 eingeführte Schrauben (hier nicht gezeigt) mit dem unteren Gehäuse verschraubt. Dabei werden die Schaumstoffelemente 19 komprimiert und die Elektrolytkondensatoren 12 gegen die Lastanschlusselemente 1, 2 gezwungen, so dass die Kontaktfüße 3, 4 wiederum gegen die jeweiligen Kontaktflächen 10, 11 gezwungen werden. Damit kann ein sicherer und zuverlässiger Kontakt zwischen den Kontaktfüßen 3, 4 und den Kontaktflächen 10, 11 hergestellt werden. Die Montage ist einfach. Indem der Druck zur Herstellung des Druckkontakts zwischen den Kontaktfüßen 3, 4 und den Kontaktflächen 10, 11 über die Elektrolytkondensatoren 12 auf die Lastanschlusselemente 1, 2 ausgeübt wird, kann ein besonders kompakter Aufbau des Leistungshalbleitermoduls erreicht werden.

### Bezugszeichenliste

- 1: erstes Lastanschlusselement
- 2: zweites Lastanschlusselement
- 3: erster Kontaktfuß
- 4: zweiter Kontaktfuß
- 5: isolierende Schicht
- 6: Durchbruch
- 7: Substrat
- 8: Leistungshalbleiter
- 9: Bondingdraht
- 10: erste Kontaktfläche
- 11: zweite Kontaktfläche
- 12: Elektrolytkondensator
- 13: erster Anschluss
- 14: zweiter Anschluss
- 15: unteres Gehäuseelement
- 16: oberes Gehäuseelement
- 17: zylindrische Ausnehmung
- 18: Decke
- 19: Schaumstoffelement
- 20: Schraubenbohrung

## Patentansprüche

1. Leistungshalbleitermodul, bei dem ein mit zumindest einem Leistungshalbleiter (8) versehenes Substrat (7) erste (10) und zweite Kontaktflächen (11) aufweist,
wobei ein erstes Lastanschlusselement (1) mit daran vorgesehenen ersten Kontaktelementen (3) auf den ersten Kontaktflächen (10) und ein zweites Lastanschlusselement (2) mit daran vorgesehenen zweiten Kontaktelementen (4) auf den zweiten Kontaktflächen (11) abgestützt sind,
und wobei zumindest ein Federelement (19) zur Erzeugung eines Druckkontakts zwischen den Kontaktelementen (3, 4) und den Kontaktflächen (10, 11) vorgesehen ist,
**dadurch gekennzeichnet, dass**
der Druckkontakt zwischen den Kontaktelementen (3, 4) und den Kontaktflächen (10, 11) über zumindest ein, zwischen dem Federelement (19) und einem der Lastanschlusselemente (1, 2) angeordnetes elektrisches Bauelement (12) ausgeübt wird.

2. Leistungshalbleitermodul nach Anspruch 1, wobei das elektrische Bauelement (12) ein Kondensator, vorzugsweise ein Elektrolytkondensator, ist.

3. Leistungshalbleitermodul nach einem der vorhergehenden Ansprüche, wobei ein den Kondensator aufnehmendes oberes Gehäuseelement (16) mit einem dazu korrespondierenden, das Substrat (7) aufnehmenden oder durch das Substrat (7) gebildeten unteren Gehäuseelement (15) verbunden ist.

4. Leistungshalbleitermodul nach einem der vorhergehenden Ansprüche, wobei das obere Gehäuseelement (16) zumindest eine zylindrische Ausnehmung zur im Wesentlichen formschlüssigen Aufnahme des Kondensators aufweist.

5. Leistungshalbleitermodul nach einem der vorhergehenden Ansprüche, wobei das Federelement (19) zwischen einer Decke (18) der Ausnehmung (17) und dem in der Ausnehmung (17) aufgenommenen Kondensator vorgesehen ist.

6. Leistungshalbleitermodul nach einem der vorhergehenden Ansprüche, wobei das Federelement (19) aus einem dauerelastischen Schaumstoffelement hergestellt oder nach Art einer Federzunge gebildet ist.

7. Leistungshalbleitermodul nach einem der vorhergehenden Ansprüche, wobei das Federelement (19) an einer Decke (18) der Ausnehmung (17) angeformt ist.

8. Leistungshalbleitermodul nach einem der vorhergehenden Ansprüche, wobei ein sich vom Kondensator ersteckender erster Anschluss (13) mit einem der ersten Kontaktelemente (3) und ein sich vom Kondensator erstreckender zweiter Anschluss (14) mit einem der zweiten Kontaktelemente (4) verbunden ist.

9. Leistungshalbleitermodul nach einem der vorhergehenden Ansprüche, wobei das zweite Lastanschlusselement (2) zumindest einen Durchbruch (6) aufweist, durch welchen eines der ersten Kontaktelemente (3) und/oder ein erster Anschluss (13) hindurchgeführt ist/sind.

10. Leistungshalbleitermodul nach einem der vorhergehenden Ansprüche, wobei die Anschlüsse (13, 14) mit den Kontaktelementen (3, 4) verlötet oder verschweißt sind.

11. Leistungshalbleitermodul nach einem der vorhergehenden Ansprüche, wobei die Anschlüsse (13, 14) zwischen den Kontaktflächen (10, 11) und den Kontaktelementen (3, 4) klemmend gehalten sind.
